# EUROPEAN PATENT APPLICATION

(11) **EP 4 803 976 A1**
(43) Date of publication of application: **09.09.2026**
(21) Application number: 26160203.1
(22) Date of filing: 23.02.2026
(51) Int. Cl.: G06F 1/184, G06F 1/185, H05K 7/14, G06F 1/186

(54) **ELECTRONIC DEVICE WITH IMPROVED CIRCUIT BOARD HOLDING SYSTEM**

(30) Priority: 28.02.2025 US 202563764610 P
(71) Applicant: Karl Storz SE & Co. KG, 78532 Tuttlingen (DE)
(72) Inventor: ROTH, Jeremy, Goleta, CA 93117 (US); ANHALT, Thomas, Goleta, CA 93117 (US); SANANDAJIFAR, Joseph, Goleta, CA 93117 (US); DEGOEDE, Grant, Goleta, CA 93117 (US); TORRES, Marco A., Goleta, CA 93117 (US)

(57) **Abstract**

The present disclosure is generally related to a device for holding a Printed Circuit Board (PCB) or similar electrical component. Some electrical devices benefit from having foam inside an outer metal enclosure to hold the various components. The foam can assist with one or more of airflow, device mounting, noise dampening and shock absorption. However, one challenge that exists, especially for high frequency electronic devices, is that the foam being in contact with the PCB can potentially cause electrical interference issues. As such, an exemplary embodiment is directed to an improved PCB securing structure. One exemplary aspect is directed to a PCB clip and support block that secure a PCB to and electrically isolate the PCB from the support block. Another exemplary aspect is directed to a monolithic PCB clip that secures a PCB to mounting foam within an enclosure and electrically isolates the PCB from the mounting foam.

## Description

### FIELD

The present invention relates to a printed circuit board (PCB) securing assembly or similar electrical components securing assembly, a PCB clip for a printed circuit board (PCB) securing assembly, and a methos of assembling an electronic device comprising PCBs, particularly assembling printed circuit board (PCB) securing assembly.

### BACKGROUND

Some electrical devices benefit from having foam inside an outer metal enclosure to hold the various components. However, one challenge that exists, especially for high frequency electronic devices, is that the foam being in contact with the PCB can potentially cause electrical interference issues.

It is an object of the present invention to provide a printed circuit board (PCB) securing assembly, which is simple to assemble, minimizes contact between the PCBs and a support structure, facilitates alignment of PCBs in the assembly, helps minimizing space occupied for a support structure, and provides a PCB clip for securing the PCBs in the assembly.

### SUMMARY

The present disclosure is directed to an improved PCB securing structure as defined by claim 1. Various embodiments and a method for assembly of the securing structure are disclosed in the dependent claims.

According to one aspect of the disclosure a printed circuit board (PCB) securing assembly comprises one more main boards, one or more card edge connectors affixed to the one or more main boards, one or more PCBs, one or more support blocks, and one or more PCB clips. Each of the one or more PCBs are secured between a card edge connector and one or more PCB clips, and each of the one or more PBC clips are secured in the support block.

According to another aspect of the disclosure PCB clips for securing a printed circuit board in a securing assembly comprise a first top plate connected to a first saddle wall, a second top plate connected to a second saddle wall, a saddle located between the first saddle wall and the second saddle wall, and a pin associated with each of the first top plate and the second top plate and extending perpendicularly to the first top plate and the second top plate, respectively. A PCB securing mechanism is configured to accommodate a slot of a PCB around at least a portion of the saddle.

One exemplary aspect is directed to a PCB clip that secures a PCB to a mounting surface or material.

One exemplary aspect is directed to a PCB clip that secures a PCB to, and electrically isolates the PCB from, a mounting surface/structure such as mounting or block foam.

Another exemplary aspect is directed to a monolithic PCB clip that secures a PCB to mounting foam within an enclosure and electrically isolates the PCB from the mounting foam.

Another exemplary aspect is directed to a monolithic plastic PCB clip that secures a PCB to a support block, particularly a mounting foam, within an enclosure and electrically isolates the PCB from the mounting foam.

Another exemplary aspect is directed to a monolithic plastic PCB clip that secures a PCB to a support block, particularly a mounting foam, within an enclosure and provides shock absorption to the PCB.

Yet another exemplary aspect is directed to a PCB clip that secures a PCB to a support block, particularly a mounting foam, isolates the PCB from the support block and provides consolidated stacking of PCBs.

Still another exemplary aspect provides a method of mounting a PCB without screws or traditional fasteners.

Yet another exemplary aspect provides a PCB clip that engages with a PCB slot to secure the PCB in the x-, y- and z-directions. The x-, y- and z-directions are oriented perpendicular to each other.

Additional exemplary aspects provide a method of mounting a PCB such that it is supported, yet floating, within an enclosure. Particularly, one or more PCBs are mounted in a floating manner within slots with one or more support blocks.

Further exemplary aspects provide a PCB mount system to suspend a PCB between a PCB clip(s) and a card edge connector on another board, such as a motherboard.

Further exemplary aspects provide a PCB mount system or securing assembly to suspend a PCB between a PCB clip(s) and a card edge connector on another board, such as a motherboard while reducing PCB-to-support structure contact. Alternatively, the PCB may be suspended between a PCB clip(s) in a first support block and a mount system of a second support or PCB clip(s) block.

Further exemplary aspects provide a PCB mount system or securing assembly to suspend a PCB between a PCB clip and a card edge connector on another board, such as a motherboard, such that the PCB floats.

Further exemplary aspects provide a PCB mount system or securing assembly to suspend a PCB between a PCB stand-off and a card edge connector on another board, such as a motherboard, such that the PCB floats.

Other exemplary aspects provide a PCB mounting system or securing assembly that improves spacing and airflow around a PCB.

Additional exemplary aspects provide a system or securing assembly that helps protect electronic components from shock loads and movement.

A further exemplary aspect is directed to a PCB clip which comprises one or more ribs located on each of the pins. Also, the PCB clip may comprise a point or cone on an end of each of the pins.

In a further exemplary aspect the first saddle wall and the second saddle wall of the PCB clip may be parallel to one another. The first saddle wall and second saddle wall may be perpendicular to the first top plate and second top plate, respectively. The PCB clip can be configured to accommodate a slot of a PCB around three sides of the saddle.

In yet a further exemplary aspect the first the first saddle wall of the first top plate and/or the second top plate includes a first portion adjacent to the saddle and a second portion that is not coplanar with the first portion.

The preceding is a simplified summary of the disclosure to provide an understanding of some aspects of the disclosure. This summary is neither an extensive nor exhaustive overview of the disclosure and its various aspects, embodiments, and configurations. It is intended neither to identify key or critical elements of the disclosure nor to delineate the scope of the disclosure but to present selected concepts of the disclosure in a simplified form as an introduction to the more detailed description presented below. As will be appreciated, other aspects, embodiments, and configurations of the disclosure are possible utilizing, alone or in combination, one or more of the features set forth above or described in detail below.

Numerous additional features and advantages are described herein and will be apparent to those skilled in the art upon consideration of the following Detailed Description and in view of the accompanying figures.

### BRIEF DESCRIPTION OF THE DRAWINGS

The accompanying drawings are incorporated into and form a part of the specification to illustrate several examples of the present disclosure. These drawings, together with the description, illustrate exemplary principles of the disclosure. The drawings simply illustrate exemplary and alternative examples of how the disclosure can be made and used and are not to be construed as limiting the disclosure to only the illustrated and described examples. Further features and advantages will become apparent from the following, more detailed, description of the various aspects, embodiments, and configurations of the disclosure, as illustrated by the drawings referenced below.

It should be understood that the drawings are not necessarily to scale. In certain instances, details that are not necessary for an understanding of the disclosure or that render other details difficult to perceive may have been omitted. It should be understood, of course, that the disclosure is not necessarily limited to the particular embodiments illustrated herein.
FIG. 1 illustrates an exemplary perspective view of a PCB clip in accordance with aspects of the present disclosure.
FIG. 2 illustrates another perspective view of an exemplary PCB clip in accordance with aspects of the present disclosure.
FIG. 3 illustrates a side view of an exemplary PCB clip in accordance with aspects of the present disclosure.
FIG. 4 illustrates a front view of an exemplary PCB clip in accordance with aspects of the present disclosure.
FIG. 5 illustrates a back view of an exemplary PCB clip in accordance with aspects of the present disclosure.
FIG. 6 illustrates a side view of an exemplary PCB clip in accordance with aspects of the present disclosure.
FIG. 7 illustrates atop view of an exemplary PCB clip in accordance with aspects of the present disclosure.
FIG. 8 illustrates an environmental view of an exemplary PCB clip engaged with a PCB in a foam mount in accordance with aspects of the present disclosure.
FIG. 9 illustrates an environmental view of an exemplary PCB clip engaged with a PCB in a foam mount in accordance with aspects of the present disclosure.
FIG. 10 illustrates an environmental view of an exemplary PCB clip engaged with a PCB in accordance with aspects of the present disclosure.
FIG. 11 illustrates an exemplary floating PCB assembly in accordance with aspects of the present disclosure.
FIG. 12 illustrates a perspective view of an exemplary floating PCB card assembly with a support block in accordance with aspects of the present disclosure.
FIG. 13 illustrates an exemplary side view of floating PCB card assembly with a support block in accordance with aspects of the present disclosure.
FIG. 14 illustrates an exemplary end view of floating PCB card assembly with a support block in accordance with aspects of the present disclosure.
FIG. 15 illustrates an exemplary side perspective view of floating PCB card assembly with support blocks in accordance with aspects of the present disclosure.

### DETAILED DESCRIPTION

Before any embodiments of the disclosure are explained in detail, it is to be understood that the disclosure is not limited in its application to the details of construction and the arrangement of components set forth in the following description or illustrated in the drawings. The disclosure is capable of other embodiments and of being practiced or of being carried out in various ways. Also, it is to be understood that the phraseology and terminology used herein is for the purpose of description and should not be regarded as limiting. The use of "including," "comprising," or "having" and variations thereof herein is meant to encompass the items listed thereafter and equivalents thereof as well as additional items. Further, the present disclosure may use examples to illustrate one or more aspects thereof. Unless explicitly stated otherwise, the use or listing of one or more examples (which may be denoted by "for example," "by way of example," "e.g.," "such as," or similar language) is not intended to and does not limit the scope of the present disclosure.

The ensuing description provides embodiments only, and is not intended to limit the scope, applicability, or configuration of the claims. Rather, the ensuing description will provide those skilled in the art with an enabling description for implementing the described embodiments. It being understood that various changes may be made in the function and arrangement of elements without departing from the spirit and scope of the appended claims.

Various aspects of the present disclosure will be described herein with reference to drawings that may be schematic illustrations of idealized configurations.

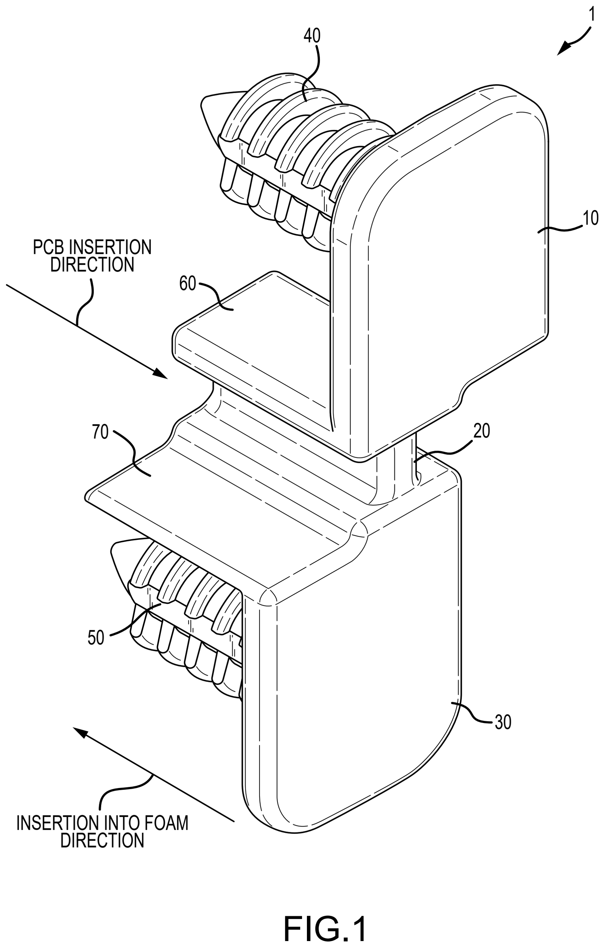

FIG. 1 illustrates an exemplary perspective view of a PCB clip 1 in accordance with aspects of the present disclosure. The exemplary clip 1 includes: a first top plate 10, a first pin 40, a first saddle wall 60, a second saddle wall 70, saddle 20, a second top plate 30 and a second pin 50.

The PCB clip 1 can be, for example, comprised of plastic, reinforced plastic, static dissipative plastic, nylon, and/or the like. The PCB clip 1 can also be monolithic and its overall dimensions, especially the width and depth of the saddle 20, adjusted to suit a specific PCB. Alternatively, the PCB clip could be metal and/or a composite. Alternatively or in addition, the PCB clip can optionally include an isolation cushion (not shown) that fits into the saddle and supports and isolates the PCB. This isolation cushion could be made of plastic, rubber, nylon, silicone and/or the like, and fit between the saddle 20 and the slot 110 in the PCB to support the PCB.

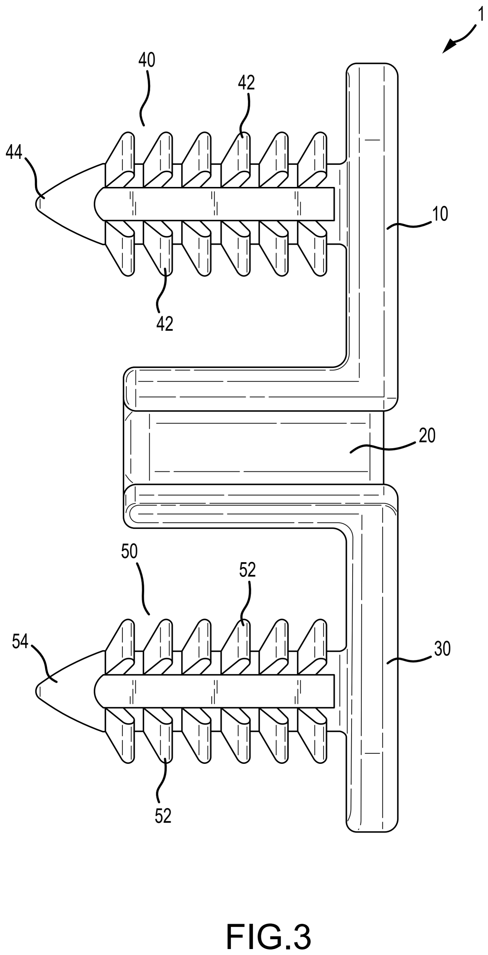

Each of the pins 40 and 50 can include one or more ridges (42, 52 as seen in FIG. 3) that can extend partially or fully around the circumference of the pin 40, 50 to assist with securing the clip 1 into a foam or other mounting structure. While this configuration is typically known as a Christmas tree fastener, it is to be appreciated that other pin geometries will work comparably well to secure the clip 1 into the foam or other mounting structure. The ridges can be made of a flexible material, such as a bendable plastic to frictionally engage with a corresponding hole in a foam support structure or other mounting structure.

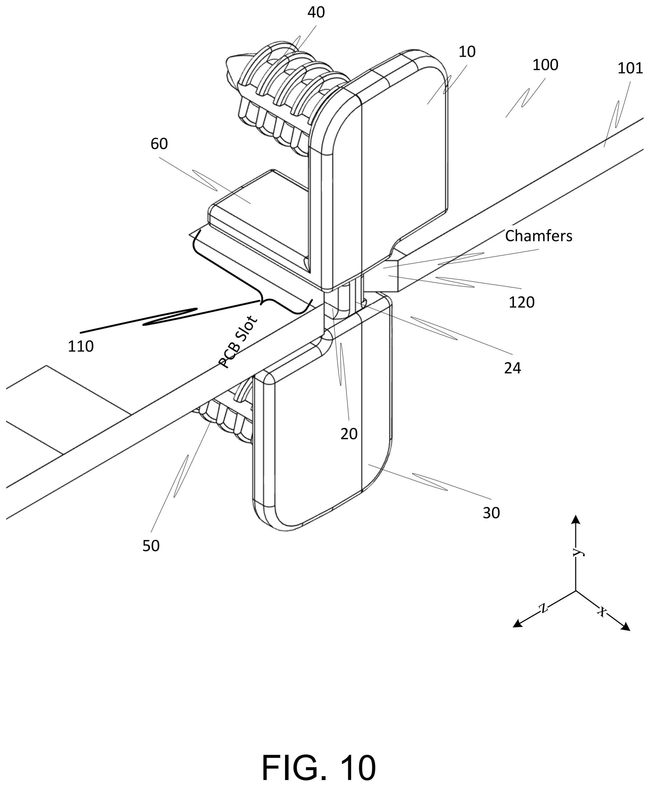

Adjacent to the saddle 20 are the first saddle wall 60 and second saddle wall 70. The first saddle wall 60 and second saddle wall 70 support a top side, and a bottom side of the PCB, respectively, adjacent to the PCB slot 110 when the PCB is inserted in the direction shown in FIG. 1. (FIG. 10 shows the PCB 100 inserted into the clip 1.)

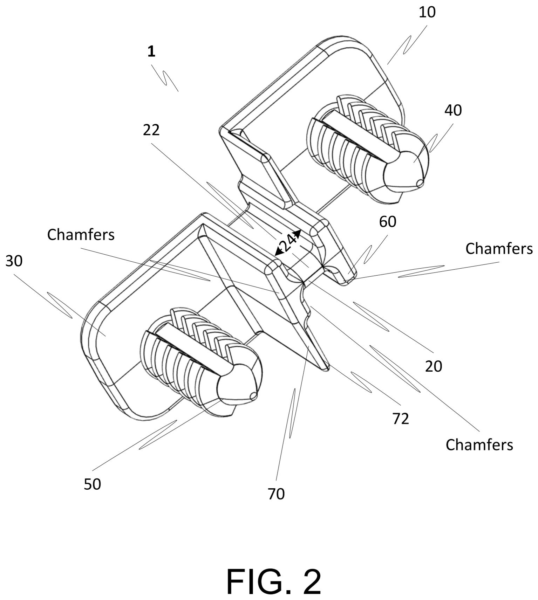

FIG. 2 illustrates a different perspective view of an exemplary PCB clip in accordance with aspects of the present disclosure.

The underside of the saddle 20 that initially receives the PCB 100 is optionally shown as being chamfered 22 to facilitate assembly, and a width 24 of the saddle can be configured to be larger than a width of the PCB to be inserted therein. Similarly, the bottom portions of the first and second saddle walls 60, 70 can also be chamfered as shown.

FIG. 3 illustrates a side view of an exemplary PCB clip in accordance with aspects of the present disclosure. The pins 40 and 50 can be seen including a plurality of fins 42, 52 with each pin 40, 50 including a tip 44, 54 such as a conical or pointed tip.

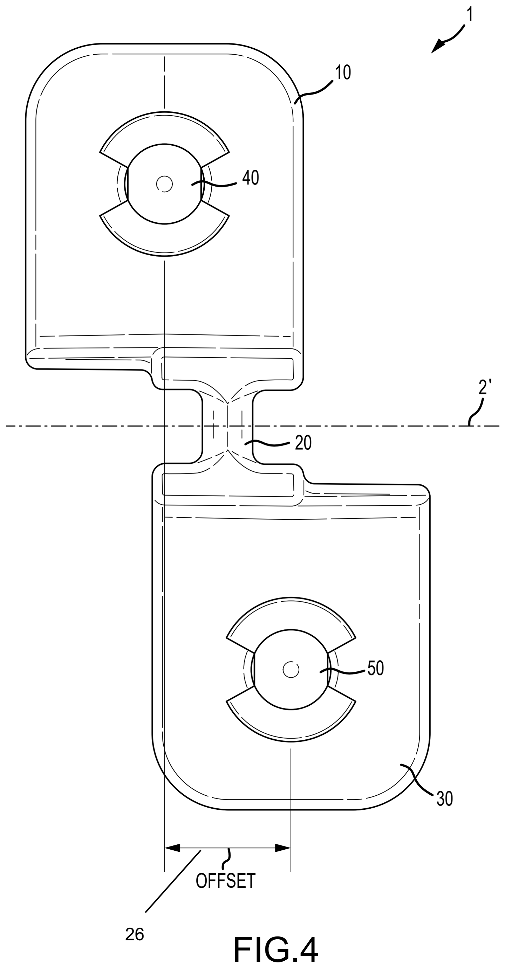

FIG. 4 illustrates a front view of an exemplary PCB clip in accordance with aspects of the present disclosure. While not required, it was found that offsetting the center line of the pins 40, 50 relative to one another facilitated the securing of the PCB and also allowed more PCBs to be secured in a tighter space, in such conditions the clips can be placed in an "over/under" configuration to avoid a lower clip associated with a higher board blocking a potential location for the upper clip of a lower board. This view also exemplifies the exemplary symmetrical configuration of the clip 10 relative to centerline 2'. The pins 40 and 50 are offset by an offset distance 26 along the centerline 2', as shown in Fig. 4. Further, the pins 40 and 50 are offset from a centerline perpendicular to centerline 2.

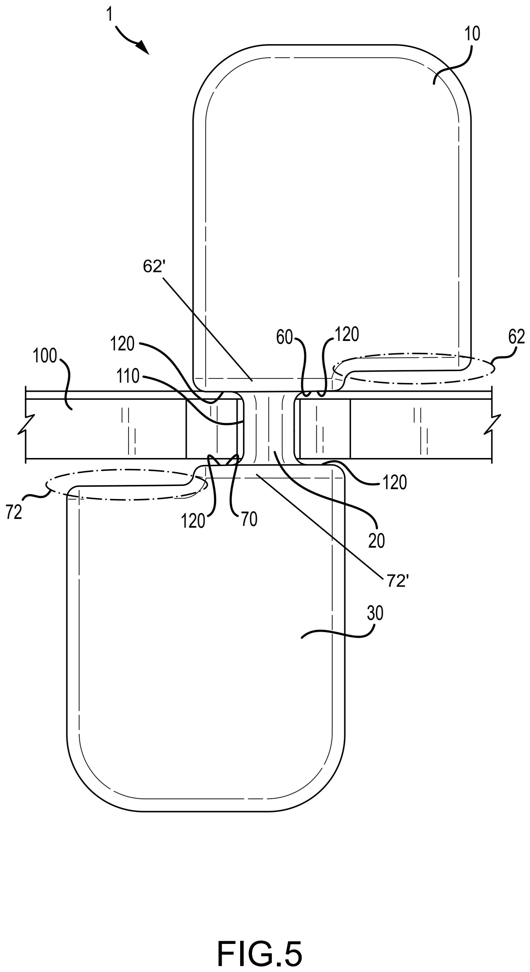

FIG. 5 illustrates a back view of an exemplary PCB clip 1 in accordance with aspects of the present disclosure with the first top plate 10, the saddle 20 and the second top plate 30. The PCB 100 is shown with the slot 110 of the PCB 100 installed in the clip 1. In this top-down view, it can be visualized how the contact areas 120 between the first saddle wall 60 and second saddle wall 70 and the PCB are minimized, to assist with reducing electrical interference on the PCB 100. The first saddle wall 60 and second saddle wall 70 support the PCB 110 therebetween, and the engagement of the saddle 20 with the slot 110 in the PCB locks the PCB into position as will be discussed hereinafter in greater detail.

In accordance with one exemplary embodiment, the first saddle wall 60 includes a first portion 62' adjacent to and optionally in contact with the PCB and adjacent to the saddle, and a second portion 62 that is not coplanar with the first portion 62'. This can assist with reducing PCB-to-clip contact. Alternatively or additionally, the second saddle 70 wall includes a first portion 72' adjacent to and optionally in contact with the PCB and adjacent to the saddle, and a second portion 72 that is not coplanar with the first portion 72'. This can assist with reducing PCB-to-clip contact. Thus, the first portions 62', 72' and the second portions 62, 72 lie in different flat, two-dimensional planes. Also, they can be slightly angled to each other.

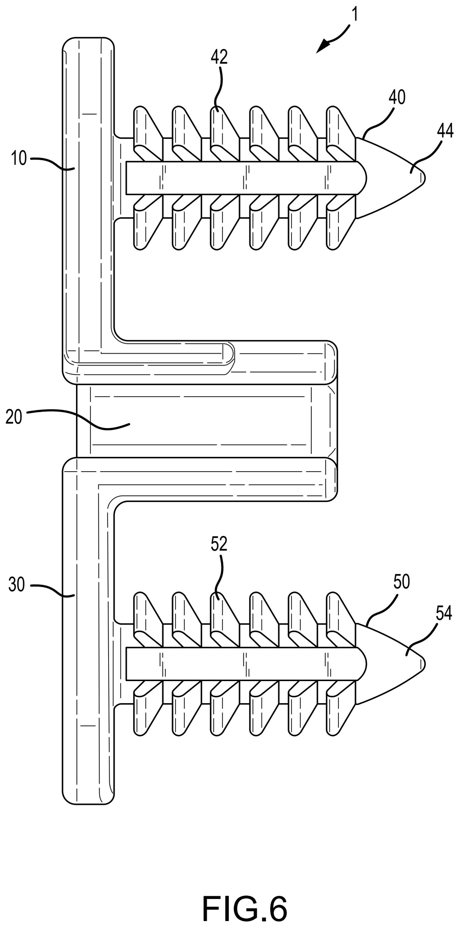

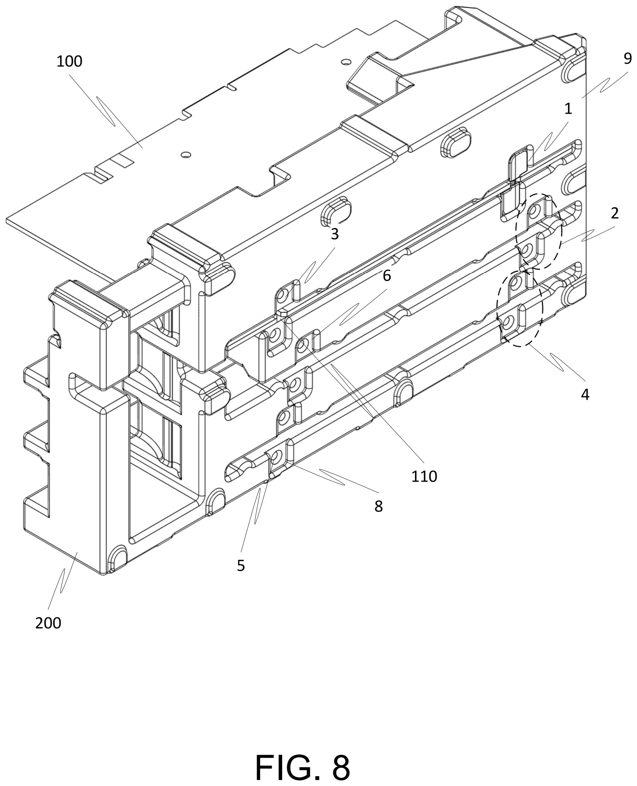

FIG. 6 illustrates another side view of an exemplary PCB clip 1 in accordance with aspects of the present disclosure, similar to FIG. 3. The pins 40 and 50 can be seen including a plurality of fins 42, 52 with each pin 40, 50 including a tip 44, 54 such as a conical, arrowhead, or pointed tip. These pins 40, 50 are inserted into corresponding holes in a foam support as shown later in the discussion of FIG. 8.

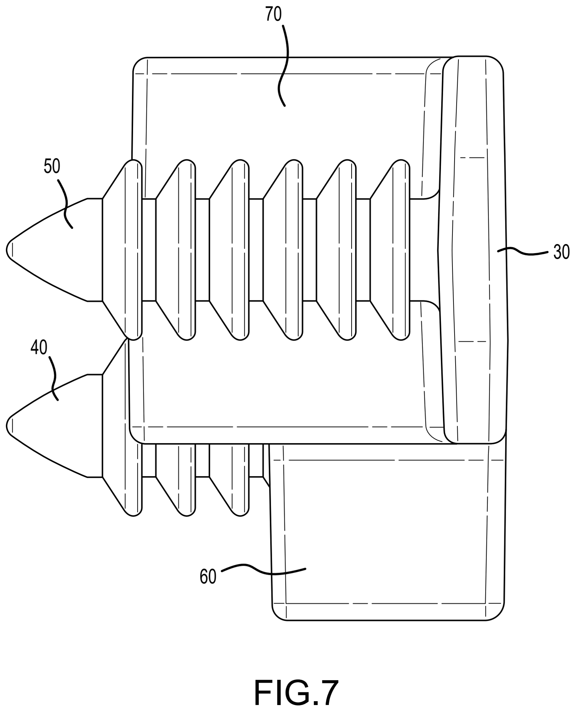

FIG. 7 illustrates an top view of an exemplary PCB clip in accordance with aspects of the present disclosure. Sides of the first saddle wall 60 and second saddle wall 70 that abut corresponding surfaces of the foam support material are visible, and the optional offset of the walls and pins 40, 50 is shown.

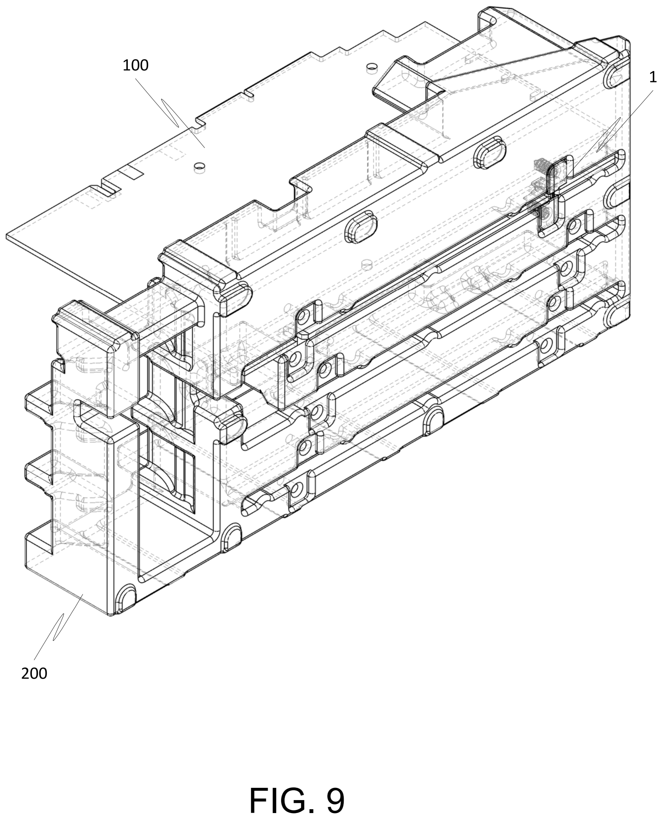

FIGS. 8-9 illustrate environmental views of an exemplary PCB clip 1 engaged with a slot 110 in a PCB 100 in a support block in form of a foam mount 200 in accordance with aspects of the present disclosure. A plurality of clip recesses 2, 6, 4 and 8 in the support block 200 are shown without clips installed, and exemplary clip 1 is shown supporting the PCB board 100. Holes that are pre-formed in the foam mount 200 are shown at 3 and 5 to receive additional clips (not shown) to be inserted in the recesses 3, 6, 8, 2 and 4. In this exemplary embodiment, the foam 200 and PCB boards 100 are configured for 2 clips to support each of the three boards (only one board is illustrated). By offsetting the positions of the clips/recesses ((1, 2, 4) and (3, 6, 8)) as shown, vertical consolidation of the boards is possible.

The recesses 2, 3, 4, 6, 8 in the support block 200 optionally will be sufficiently deep such that when the clip 1 is placed in the foam 200 the top of the clip sits flush with or below a surface 9 of the foam 200.

Complementary pairs of the clips inserted at 1, 3 and 2, 6 and 4, 8 are configured to support the PCB 100 while reducing contact between the foam support 200 and the PCB.

FIG. 10 illustrates an environmental perspective view of an exemplary PCB clip engaged with a PCB 100 in accordance with aspects of the present disclosure. The PCB slot 110 is configured such that it is narrower in the z direction than the width of the saddle, and also thinner in the y direction that the width between the inner saddle walls 60, 70. Through this configuration, the PCB 100 is supported in the x, y and z dimensions with the PCB 100 located between the saddle walls 60 and 70. The PCB 100 can optionally also be chamfered 120 and the PCB slot depth optionally be cut such that the edge 101 of the PCB is approximately at the same height as the top of the saddle at 24 when viewed in the x direction.

One consideration is that it that it may be preferred to avoid any circuit traces coming into contact with the clip 1 and thereby potentially causing interference with signals thereon.

Another consideration, is that the avoidance of circuit traces coming into contact with the clip 1 could help avoid damage to those traces during installation of the board and clips.

One exemplary benefit of such a configuration is that PCB boards can be held securely, in a "fastenerless" manner, with improved electrical isolation from any mounting devices. In particular, no metal screws, as are common in the current state of the art, are needed to hold the PCBs in place, facilitating, thereby assembly, disassembly, and troubleshooting of the device.

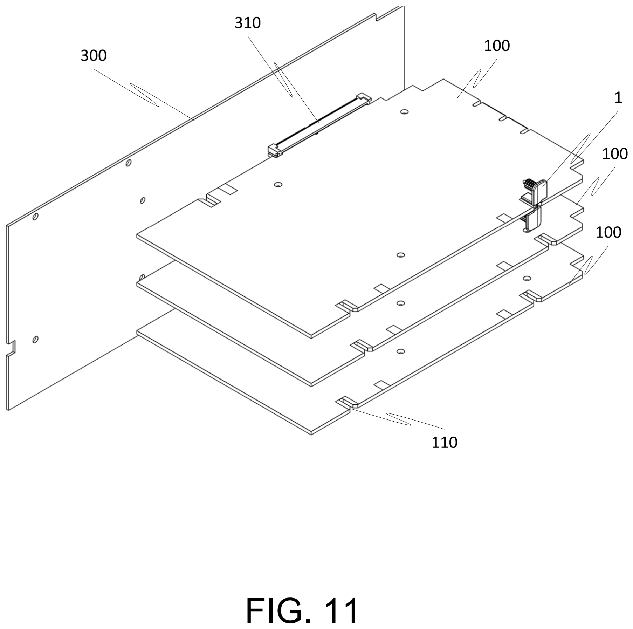

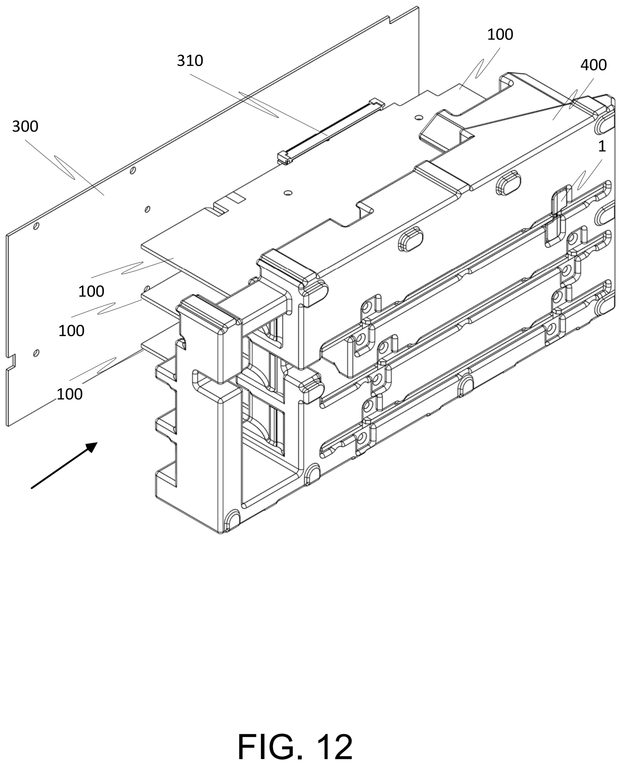

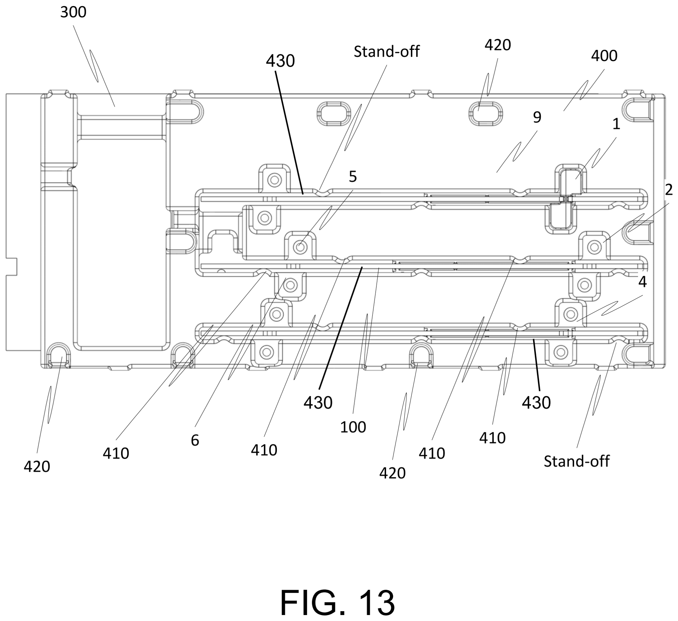

FIG. 11 illustrates exemplary "floating PCB" assemblies using a plurality of the clips 1 (only one shown) in accordance with aspects of the present disclosure. A main board 300, such as a motherboard, includes a plurality of card edge connectors 310, such as PCIe connectors, or the like, that support a first side of each of the PCBs 100. On an opposite side of each of the PCBs, the PCBs are supported in slots 430 of the support block 200 by one or more of: one or more clips 1, and one or more stand-offs 410 shown in FIG. 13. As discussed, the clips 1 are inserted into slots 110 on the PCBs and the clips themselves installed in a support structure such as foam (see FIG. 12-15) or another support structure as discussed herein. While the clips are shown opposite the card edge connectors 310 in FIG. 11, the clip(s) 1 can be placed on any one or more of the sides of the PCBs 100. Similarly, the support blocks discussed hereinafter can be located on any one or more of the sides of the PCBs. In accordance with one exemplary embodiment, only the card edge connector 310, the clips 1, and optionally the one or more stand-offs are in contact with the PCBs. (Of course, other electrical connections necessary for the proper functioning of the PCBs, such as cables, ribbon connectors, heat sinks, etc., could also be in contact with the PCBs).

FIG. 12 illustrates a perspective view of exemplary floating PCB assemblies with a support block 400 in accordance with aspects of the present disclosure. The support block 400 can be in any size, shape, material(s), number of pieces and/or configuration provided it supports a number of PCBs attached to the main board 300. In this exemplary embodiment, the support block 400 is a foam material, and as high frequency PCBs 100 are highly sensitive, the PCBs are kept largely physically isolated from all other devices in the assembly. The support block 400 corresponds to the support block 200 as described above.

The support block 400 can be of any size and shape, may be configured to facilitate airflow, and can be a single piece or multiple pieces. The support block(s) 400 can also be on one or more sides of the PCBs and is not limited to just the top edge as shown. The support block can also be one or more types of material, including insulating foam, static dissipative foam, sound deadening foam and/or the like. While the main board 300, PCBs 100 and support block 400 are shown in a specific orientation, these various components can be reconfigured into any orientation such as with the PCBs vertically oriented and the main board 300 horizontally oriented, and the like.

The support block(s) 200 and 400 can be injection molded foam, cast foam, machined foam, 3D printed foam, or the like, and can be of varying rigidities, softnesses, hardnesses, and the like.

In this exemplary embodiment, the foam is expanded polypropylene.

FIG. 13 illustrates an exemplary side view of floating PCB card assemblies with a support block 400 in accordance with aspects of the present disclosure. The clip(s) 1 and clip recesses 2, 4, 6 and 8 are shown in a partially assembled state with clip 1 in place partially supporting a first PCB, and additional clips needing insertion into the block 400 in recesses 2, 4, 6 and 8 to support the additional PCBs 100 for completion of the assembly. Optional stand-offs 410 can be included anywhere along the PCB edges, with in this exemplary embodiment four to five stand-offs provided for each PCB. These stand-offs could be of a different material than the block 400, such as an insulative material, shock absorbing material, or the like. The areas of the block 400 adjacent to the stand-offs are optionally not in contact with the PCBs leaving a slot 430 in the block 400 into which the PCBs are inserted and are housed. The stand-offs can extend any extent toward the main board 300 and can be of any shape.

The block 400 can optionally include one or more spacers 420 configured to provide a gap between the block 400 and an enclosure (not shown) when the assembly is mounted in a chassis. This can, for example, also assist with shock absorption as well as air circulation around the various components.

The block 400 could also optionally include a thin cover (not shown) that could cover one or more portions of the surface 9 and slot(s) in the block 400 to, for example, assist with controlling air flow for the device.

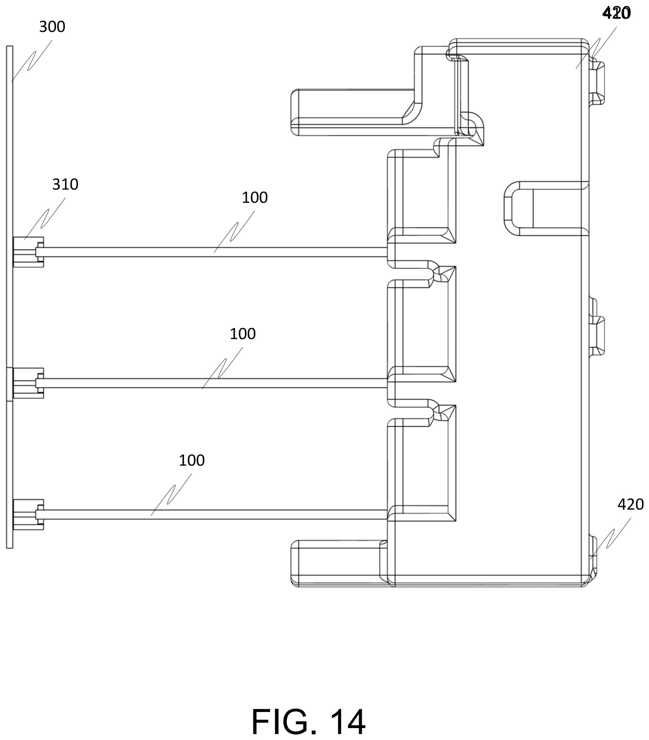

FIG. 14 illustrates an exemplary end view of a floating PCB card assembly with a support block in accordance with aspects of the present disclosure. This end view is from the perspective of the bold arrow in FIG. 12. The cards have been placed to extend between the card edge connectors 310 and the block 400 with sufficient spacing therebetween for cooling. The spacers 420 could fit against an adjacent portion of a chassis (not shown) and from this side view can be seen as providing a space for airflow.

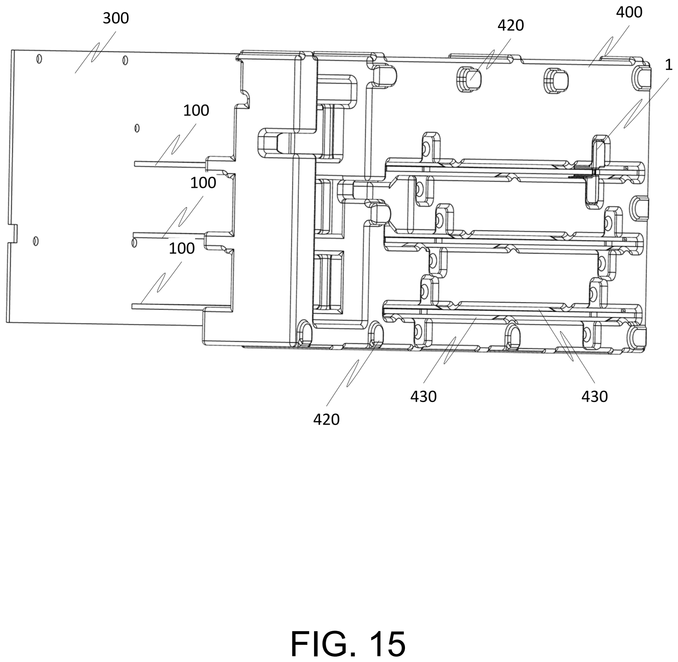

FIG. 15 illustrates an exemplary side, perspective views of floating PCB card assemblies with support blocks in accordance with aspects of the present disclosure. These views provide visibility into the slots 430 above and below the PCBs 100 further illustrating how they are "floating" in the enclosure between the various supports. This view also provides good visibility into the space available for airflow around the PCBs for cooling.

To assemble an exemplary device, the PCBs 100 are pushed into the card edge connectors 310. Next, the block 400 is fitted over the PCBs such that the PCBs fit into the slots 430 of the support block. Then, the clips 1 are placed into the respective recesses thereby securing the PCBs in the block 400. It is particularly advantageous that an entire PCB assembly thus can be assembled outside of a containing chassis, permitting the manipulation of the assembly in order to test any number of electrical connections and contacts on and off the PCBs prior to final assembly within a chassis. A method for assembly, may thus include assembling a set of PCB boards to a main board, supporting the PCB boards on support blocks, securing the PCB boards within the blocks by means of the clips, and then placing the completed PCB assembly or assemblies within an external chassis, while making any mechanical, optical, and/or electronic connections (such as ground, data transfer, USB, power, etc. connections) necessary between the chassis and the PCB assembly. Likewise, if service is required, it is relatively simple to remove the majority of the electronic components of the system from a containing chassis for testing, replacement, or repair, simply by opening the chassis, disconnecting any electronic and mechanical connections between the PCB assembly and the chassis, and then removing the PCB assembly as a single unit (or multiple units if multiple PCB assemblies are present). Access to traces and testing points on the PCBs are more easily accessible than in conventional PCB assemblies wherein portions are secured to and within a rigid chassis.

Any of the steps, functions, and operations discussed herein can be performed continuously and/or automatically.

While the steps have been discussed and illustrated in relation to a particular sequence of events, it should be appreciated that changes, additions, and omissions to this sequence can occur without materially affecting the operation of the disclosed embodiments, configuration, and aspects.

Although the figures are largely shown in solid lines, it should be understood that one or more aspects may not form part of the claimed invention or design but rather is only a portion of an environment surrounding the claimed invention or design and/or a portion of an environment in which the claimed invention or design operates. In one non-limiting example, any or all of the PCBs may or may not form part of the claimed invention or design but rather is only a portion of an environment surrounding the claimed invention or design and/or a portion of an environment in which the claimed invention or design operates. Therefore, the description through the present disclosure should not be interpreted as a limitation on the scope of the present disclosure but merely an illustration.

The exemplary assemblies, systems and methods of this disclosure have been described in relation to a clip retainer system. However, to avoid unnecessarily obscuring the present disclosure, the preceding description may omit a number of known structures and devices. This omission is not to be construed as a limitation of the scope of the claimed disclosure. Specific details are set forth to provide an understanding of the present disclosure. It should, however, be appreciated that the present disclosure may be practiced in a variety of ways beyond the specific detail set forth herein.

A number of variations and modifications of the disclosure can be used. It would be possible to provide for some features of the disclosure without providing others. In addition, it would be possible to combine some features of the disclosure without combining all.

References in the specification to "an aspect," "one embodiment," "an embodiment," "an example embodiment," "some embodiments," etc., indicate that the embodiment described may include a particular feature, structure, or characteristic, but every embodiment may not necessarily include the particular feature, structure, or characteristic. Moreover, such phrases are not necessarily referring to the same embodiment. Further, when a particular feature, structure, or characteristic is described in conjunction with one embodiment, it is submitted that the description of such feature, structure, or characteristic may apply to any other embodiment unless so stated and/or except as will be readily apparent to one skilled in the art from the description. The present disclosure, in various embodiments, configurations, and aspects, includes components, methods, processes, systems and/or apparatus substantially as depicted and described herein, including various embodiments, sub-combinations, and subsets thereof. Those of skill in the art will understand how to make and use the systems and methods disclosed herein after understanding the present disclosure. The present disclosure, in various embodiments, configurations, and aspects, includes providing devices and processes in the absence of items not depicted and/or described herein or in various embodiments, configurations, or aspects hereof, including in the absence of such items as may have been used in previous devices or processes, e.g., for improving performance, achieving ease, and/or reducing cost of implementation.

The foregoing discussion of the disclosure has been presented for purposes of illustration and description. The foregoing is not intended to limit the disclosure to the form or forms disclosed herein. In the foregoing Detailed Description for example, various features of the disclosure are grouped together in one or more embodiments, configurations, or aspects for the purpose of streamlining the disclosure. The features of the embodiments, configurations, or aspects of the disclosure may be combined in alternate embodiments, configurations, or aspects other than those discussed above. This method of disclosure is not to be interpreted as reflecting an intention that the claimed disclosure requires more features than are expressly recited in each claim. Rather, as the following claims reflect, inventive aspects lie in less than all features of a single foregoing disclosed embodiment, configuration, or aspect. Thus, the following claims are hereby incorporated into this Detailed Description, with each claim standing on its own as a separate preferred embodiment of the disclosure.

Moreover, though the description of the disclosure has included description of one or more embodiments, configurations, or aspects and certain variations and modifications, other variations, combinations, and modifications are within the scope of the disclosure, e.g., as may be within the skill and knowledge of those in the art, after understanding the present disclosure. It is intended to obtain rights, which include alternative embodiments, configurations, or aspects to the extent permitted, including alternate, interchangeable and/or equivalent structures, functions, ranges, or steps to those claimed, whether or not such alternate, interchangeable and/or equivalent structures, functions, ranges, or steps are disclosed herein, and without intending to publicly dedicate any patentable subject matter.

Any one or more of the features as substantially disclosed herein in combination with any one or more other features as substantially disclosed herein.

Any one of the aspects/features/embodiments in combination with any one or more other aspects/features/embodiments.

Use of any one or more of the aspects or features as disclosed herein.

It is to be appreciated that any feature described herein can be claimed in combination with any other feature(s) as described herein, regardless of whether the features come from the same described embodiment.

As used herein, the singular forms "a," "an," and "the" are intended to include the plural forms as well, unless the context clearly indicates otherwise. It will be further understood that the terms "include," "including," "includes," "comprise," "comprises," and/or "comprising," when used in this specification, specify the presence of stated features, integers, steps, operations, elements, and/or components, but do not preclude the presence or addition of one or more other features, integers, steps, operations, elements, components, and/or groups thereof. The term "and/or" includes any and all combinations of one or more of the associated listed items. The use of "including," "comprising," or "having" and variations thereof herein is meant to encompass the items listed thereafter and equivalents thereof as well as additional items. Accordingly, the terms "including," "comprising," or "having" and variations thereof can be used interchangeably herein.

The transitional phrase "consisting of" excludes any element, step, or ingredient not specified in the claim, but does not exclude additional components or steps that are unrelated to the disclosure such as impurities ordinarily associated therewith. The transitional phrase "consisting essentially of" limits the scope of a claim to the specified materials or steps and those that do not materially affect the basic and novel characteristic(s) of the claimed invention.

The term "a" or "an" entity refers to one or more of that entity. As such, the terms "a" (or "an"), "one or more," and "at least one" can be used interchangeably herein. It is also to be noted that the terms "comprising," "including," and "having" can be used interchangeably.

The phrases "at least one," "one or more," "or," and "and/or" are open-ended expressions that are both conjunctive and disjunctive in operation. For example, each of the expressions "at least one of A, B and C," "at least one of A, B, or C," "one or more of A, B, and C," "one or more of A, B, or C," and "A, B, and/or C" means A alone, B alone, C alone, A and B together, A and C together, B and C together, or A, B, and C together. When each one of A, B, and C in the above expressions refers to an element, such as X, Y, and Z, or a class of elements, such as X₁-Xₙ, Y₁-Yₘ, and Z₁-Zₒ, the phrase is intended to refer to a single element selected from X, Y, and Z, a combination of elements selected from the same class (e.g., X₁ and X₂) as well as a combination of elements selected from two or more classes (e.g., Y₁ and Zₒ).

The term "automatic" and variations thereof, as used herein, refers to any process or operation, which is typically continuous or semi-continuous, done without material human input when the process or operation is performed. However, a process or operation can be automatic, even though performance of the process or operation uses material or immaterial human input, if the input is received before performance of the process or operation. Human input is deemed to be material if such input influences how the process or operation will be performed. Human input that consents to the performance of the process or operation is not deemed to be "material."

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and this disclosure.

Unless otherwise indicated, all numbers expressing quantities, dimensions, conditions, ratios, ranges, and so forth used in the specification and claims are to be understood as being modified in all instances by the term "about" or "approximately." Accordingly, unless otherwise indicated, all numbers expressing quantities, dimensions, conditions, ratios, ranges, and so forth used in the specification and claims may be increased or decreased by approximately 5% to achieve satisfactory results. Additionally, where the meaning of the terms "about" or "approximately" as used herein would not otherwise be apparent to one of ordinary skill in the art, the terms "about" and "approximately" should be interpreted as meaning within plus or minus 5% of the stated value.

It should be understood that every maximum numerical limitation given throughout this disclosure is deemed to include each and every lower numerical limitation as an alternative, as if such lower numerical limitations were expressly written herein. Every minimum numerical limitation given throughout this disclosure is deemed to include each and every higher numerical limitation as an alternative, as if such higher numerical limitations were expressly written herein. Every numerical range given throughout this disclosure is deemed to include each and every narrower numerical range that falls within such broader numerical range, as if such narrower numerical ranges were all expressly written herein.

### LISTING OF REFERENCE NUMBERS

1 - Clip
2, 3, 4, 6, 8 - Recesses/holes
10 - First top plate
20 - Saddle
22 - Chamfer
24 - Width
26 - Offset distance
30 - Second top plate
40 - First pin
50 - Second pin
60 - First saddle wall
70 - Second saddle wall
62', 72' first portion
62, 72 - Secondary portion of the saddle walls
42, 52 - Ridge/fin on pin
44, 54 - Tip of te pin
100 - Printed circuit board (PCB)
101 - PCB edge
110 - Slot in PCB
120 - Contact areas between saddle walls and PCB
200 -Support block
300 - Main board
310 - Card edge connector
400 - Support block
410 - Optional stand-offs
420 - Optional spacers
430 - Slot in support block

## Claims

1. Printed circuit board (PCB) securing assembly comprising:
one or more main boards (300);
one or more card edge connectors (310) affixed to the one or more main boards (300);
one or more PCBs (100);
one or more support blocks (200; 400); and
one or more PCB clips (1),
wherein:
each of the one or more PCBs (100) are secured between a card edge connector (310) and one or more PCB clips (1), and
each of the one or more PCB clips (1) are secured in the support block (200; 400).

2. Printed circuit board (PCB) securing assembly according to the preceding claim,
wherein each of the one or more PCB clips (1) comprise:
a first top plate (10) connected to a first saddle wall (60);
a second top plate (30) connected to a second saddle wall (70);
a saddle (20) located between the first saddle wall (60) and the second saddle wall (70); and
a pin (40; 50) associated with each of the first top plate (10) and the second top plate (30) and extending perpendicularly to the first top plate (10) and the second top plate (30), respectively,
wherein a PCB securing mechanism is configured to accommodate a slot (110) of a PCB (100) around at least a portion of the saddle (20).

3. Printed circuit board (PCB) securing assembly according to the preceding claim, further comprising one or more ribs (42; 52) located on each of the pins (40; 50).

4. Printed circuit board (PCB) securing assembly according to any of claims 2 or 3, further comprising a point or cone (44; 54) on an end of each of the pins (40; 50).

5. Printed circuit board (PCB) securing assembly according to any of the preceding claims 2-4, wherein the first saddle wall (60) and the second saddle wall (70) are parallel to one another,
and the first saddle wall (60) and second saddle wall (70) are perpendicular to the first top plate (10) and second top plate (30), respectively,
and the PCB clip (1) is configured to accommodate a slot (110) of a PCB (100) around three sides of the saddle (20).

6. Printed circuit board (PCB) securing assembly according to any of the preceding claims, further comprising one or more stand-offs (410) located in a slot (430) of the one or more support blocks (200; 400).

7. Printed circuit board (PCB) securing assembly according to any of the preceding claims, further comprising a plurality of recesses (2, 3, 4, 6, 8) in the support block (200; 400) configured to receive respective ones of the PCB clips (1).

8. Printed circuit board (PCB) securing assembly according to any of the preceding claims 2-7, wherein the pins (40; 50) are configured to be inserted into the one or more support blocks (200; 400) or other mounting structure.

9. Printed circuit board (PCB) securing assembly according to any of the preceding claims 2-8, wherein the pins (40: 50) are laterally offset from a longitudinal centerline of the PCB securing mechanism.

10. Printed circuit board (PCB) securing assembly according to any of the preceding claims 2-9, wherein the first saddle wall (60; 70) of the first top plate (10) and/or the second top plate (30) includes a first portion (62'; 72') adjacent to the saddle (20) and a second portion (62; 72) that is not coplanar with the first portion.

11. Printed circuit board (PCB) securing assembly according to any of the preceding claims, wherein the PCB clips (1) are one or more of a plastic, nylon, reinforced plastic, reinforced nylon and silicone and, in particular, are monolithic.

12. Printed circuit board (PCB) securing assembly according to any of the preceding claims, wherein the PCB clips (1) are configured to be inserted in corresponding holes in a support block (200; 400), and a slot (110) of one PCB (100) inserted around the saddle (20).

13. Printed circuit board (PCB) securing assembly according to any of the preceding claims, wherein the PCB clips (1) are configured to provide support in the x, y and z directions.

14. Printed circuit board (PCB) securing assembly according to any of the preceding claims, wherein a bottom of the saddle (20) is chamfered and/or slots (110) in the PCBs (100) are chamfered.

15. Method of assembling an electronic device comprising PCBs (printed circuit boards), comprising:
pushing one or more PCBs (100) into respective card edge connectors (310);
fitting a support block (200; 400) over the one or more PCBs (100) such that the PCBs fit into respective slots (430) in the support block (200, 400);
placing one or more PCB clips (1) according to any of the above claims into respective recesses (2, 3, 4, 6, 8) in the support block (200; 400) to secure the one or more PCBs (100) in the support block (200; 400).
